Europäisches Patentamt

European Patent Office

Office européen des brevets

(19)

(11) Numéro de publication: **0 289 439**
**A1**

(12) **DEMANDE DE BREVET EUROPEEN**

(21) Numéro de dépôt: 88450015.8

(22) Date de dépôt: **21.04.88**

(51) Int. Cl.⁴: **H 05 K 5/00**

(30) Priorité: 22.04.87 FR 8705876

(43) Date de publication de la demande:
**02.11.88 Bulletin 88/44**

(84) Etats contractants désignés: **CH DE GB IT LI**

(71) Demandeur: **POWER COMPACT, Société Anonyme:**
**Chemin de Magret Avenue Kennedy**
**F-33700 Merignac (FR)**

(72) Inventeur: **Mallet, Jean-Louis**
**387 avenue de Verdun**
**F-33700 Merignac (FR)**

**Landais, Jean-Louis**
**44 rue A. Rubinstein**
**F-33700 Merignac (FR)**

(74) Mandataire: **Thébault, Jean-Louis**
**Cabinet Thébault S.A. 50 Cours de Verdun**
**F-33000 Bordeaux (FR)**

(54) **Procédé d'assemblage de circuits de puissance et de circuits de commande sur plusieurs niveaux sur un même module et module ainsi obtenu.**

(57) Le procédé de l'invention consiste à regrouper sur un niveau, dit bas, les circuits de puissance (1), à regrouper sur au moins un niveau (3), dit à mi-hauteur, les circuits de commande, à constituer les liaisons électriques entre les circuits des deux niveaux par des pièces en forme de ressorts hélicoïdaux (4) en matériau métallique relativement rigide et soudable, disposés verticalement, à souder les extrémités inférieures des ressorts (4) aux endroits appropriés des circuits du niveau bas (1), en maintenant les ressorts à l'aide d'une plaque de guidage (13) à fixer le mur (6) du module, à placer à l'intérieur du mur, à l'aide de saillies de positionnement (8) le substrat (3) portant les cirduits de commande, à souder les extrémités supérieures des ressorts (4) aux endroits appropriés sur la face supérieure du substrat, et, enfin, à remplir de résine l'intérieur du mur.
- Application aux modules électroniques notamment de puissance.

FIG.3.

EP 0 289 439 A1

## Description

## PROCEDE D'ASSEMBLAGE DE CIRCUITS DE PUISSANCE ET DE CIRCUITS DE COMMANDE SUR PLUSIEURS NIVEAUX SUR UN MEME MODULE ET MODULE AINSI OBTENU

La présente invention a trait à un procédé pour assembler sur un même module et sur plusieurs niveaux des circuits de puissance et des circuits de commande.

Les modules électroniques de puissance comportent généralement sur le même support, à la fois des semi-conducteurs de puissance et des circuits de commande. Les premiers ont pour caractéristique de dissiper de la chaleur et sont, pour cette raison, fixés sur une ou plusieurs plaquettes en matériau céramique qui sont elles-mêmes solidarisées, par collage ou soudage, avec une semelle métallique chargé de dissiper la chaleur engendrée par lesdits circuits de puissance.

Les circuits de commande, qui dissipent peu ou pas de chaleur, sont également montés sur des plaquettes céramiques à côté des circuits de puissance, ce qui pose le double problème de l'encombrement en surface du module et des risques de dérive thermique auxquels sont sujets généralement les circuits de commande, risques renforcés par la présence très proche des circuits dissipateurs de chaleur.

Le but de l'invention est de pallier ces inconvénients en proposant une nouvelle technique d'assemblage sur plusieurs niveaux des circuits de puissance et de commande d'un même module.

A cet effet, l'invention a pour objet un procédé d'assemblage de circuits de puissance et de circuits de commande sur plusieurs niveaux sur un même module, caractérisé en ce qu'il consiste :

- à regrouper sur un niveau, dit bas, les circuits de puissance, montés sur une ou plusieurs plaquettes de céramique solidarisées d'une semelle dissipatrice de chaleur,

- à regrouper sur au moins un niveau, dit à mi-hauteur, les circuits de commande, montés sur un substrat approprié,

- à constituer les liaisons électriques entre les circuits des deux niveaux susdits par des pièces en forme de ressorts hélicoïdaux en matériau métallique relativement rigide et soudable, disposés verticalement,

- à souder les extrémités inférieures desdits ressorts aux endroits appropriés des circuits du niveau bas, en maintenant les ressorts à l'aide d'une plaque de guidage percée de trous de passage des ressorts, ladite plaque servant également au positionnement en vue du soudage des connecteurs de puissance,

- à fixer le mur du module sur ladite semelle,

- à placer à l'intérieur du mur, à l'aide de saillies de positionnement conformées sur la paroi interne dudit mur, le substrat portant les cirduits de commande,

- à souder les extrémités supérieures desdits ressorts aux endroits appropriés sur la face supérieure dudit substrat, muni à cet effet de trous de passage des ressorts, et, enfin,

- à remplir de résine l'intérieur du mur en recouvrant le niveau bas et le niveau à mi-hauteur, les connecteurs de puissance et de petits signaux dépassant de la couche de résine.

Une telle technique permet de réaliser de manière rapide et facile des modules remarquablement compacts, insensibles aux problèmes de dilatations liés aux élévations de température, ainsi qu'aux chocs et donc particulièrement fiables.

D'autres caractéristiques et avantages ressortiront de la description qui va suivre d'un mode de mise en oeuvre du procédé de l'invention, description donnée à titre d'exemple uniquement et en regard des dessins annexés sur lesquels :

- Figure 1 est une vue en perspective avec arraché partiel d'un module conforme à l'invention ;

- Figure 2 illustre la phase de soudage de l'extrémité inférieure des ressorts de liaison électrique entre les deux niveaux d'un module selon l'invention, et

- Figure 3 est une coupe verticale transversale d'un module conforme à l'invention.

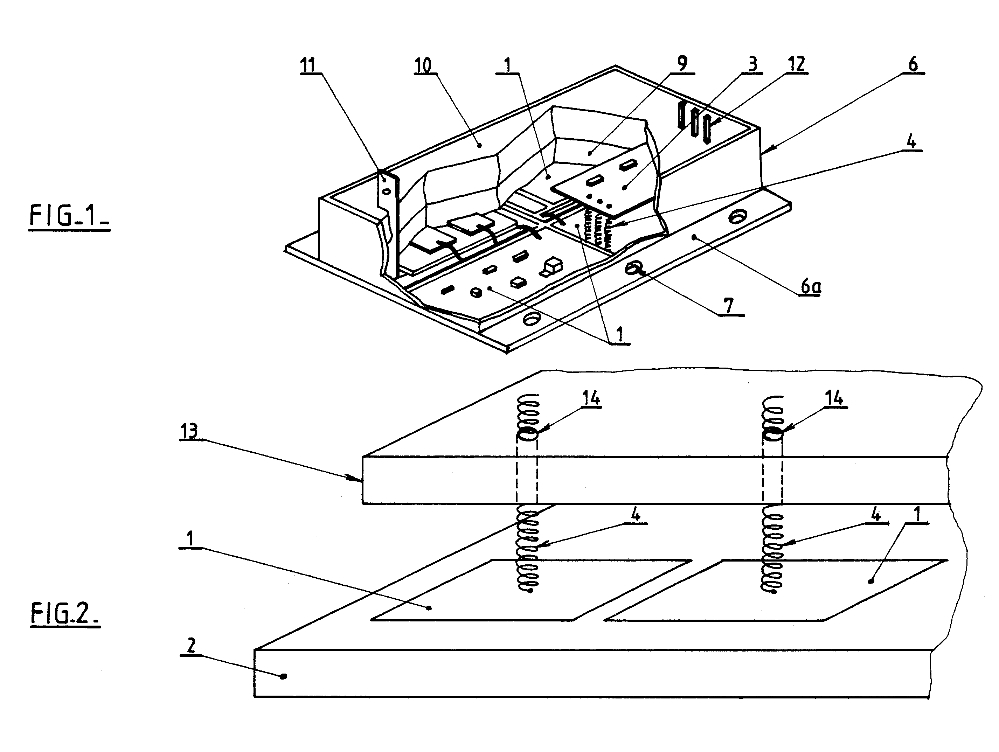

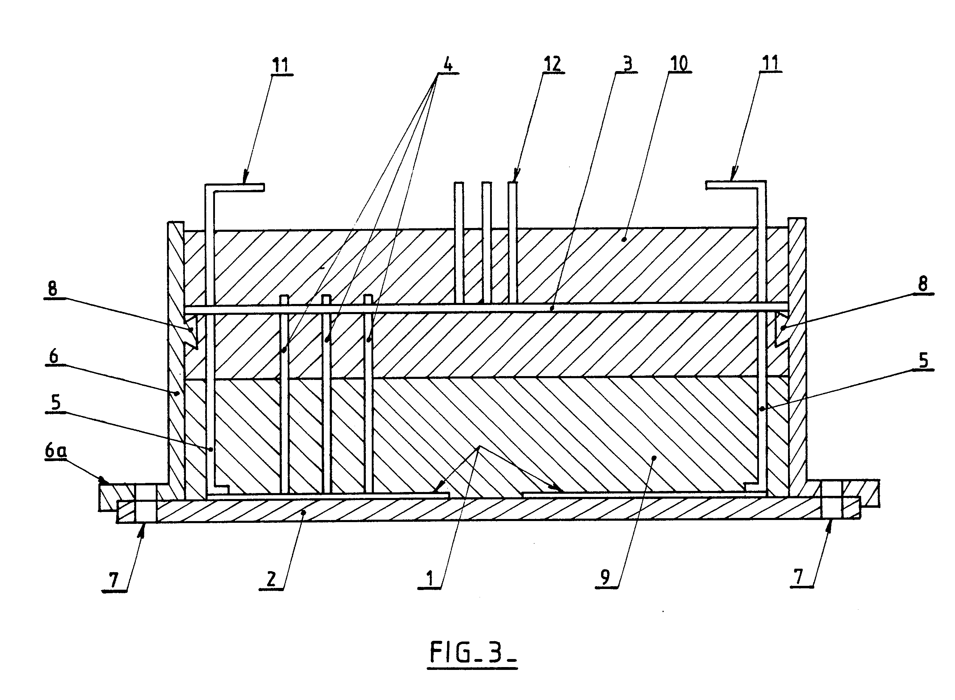

Les modules représentés schématiquement sur les figures 1 et 3 sont des modules de puissance dont les composants et circuits sont regroupés sur deux niveaux superposés.

Au niveau bas sont regroupés les circuits dits de puissance, c'est-à-dire susceptibles de générer de la chaleur, et qui sont, à la manière connue, fixés ou constitués sur plusieurs plaquettes 1 en matériau céramique, elles-mêmes fixées, par soudage ou collage par exemple, sur une semelle 2 chargée de dissiper la chaleur, en cuivre ou alumine notamment.

A un niveau dit mi-hauteur sont regroupés les circuits dits de commande qui sont réalisés ou rapportés sur un substrat constitué par une plaquette 3 de dimensions variées suivant le nombre de circuits portés, la disposition des liaisons électriques 4 entre les deux niveaux et la répartition des connecteurs de puissance 5 amenant en surface du module les bornes d'accès aux circuits de puissance des plaquettes 1.

Les circuits sont contenus à l'intérieur d'un boîtier isolant ouvert appelé mur 6, entourant complètement les circuits, muni de brides latérales 6a et solidarisé de la semelle 2. Des trous 7 ménagés dans les brides latérales 6a et à la périphérie de la semelle 2 permettent la fixation du module sur son support de réception.

Les liaisons électriques 4 entre les deux niveaux sont réalisées, conformément à l'invention, par des pièces en forme de ressorts hélicoïdaux en matériau métallique relativement rigide et permettant le soudage. Le diamètre des ressorts 4 est par exemple de l'ordre du millimètre. Les ressorts ont tous la même longueur. Ils sont soudés à leur extrémité inférieur aux endroits appropriés sur les plaquettes 1, ainsi qu'à leur extrémité supérieure aux endroits appropriés des circuits portés par la plaquette à mi-hauteur 3. A cet effet, la plaquette 3 est munie de trous de passage des extrémités des ressorts 4 afin de permettre le soudage de ces dernières après mise en place de la plaquette 3.

Pour faciliter la mise en place correcte et précise de la plaquette 3, celle-ci repose sur une banquette constituée par une ou plusieurs saillies 8 conformées sur la face interne du mur. La ou les saillies 8 sont réalisées de préférence par moulage en même temps que le mur 6 et s'étendent ou non sur toute la périphérie intérieure du mur.

La plaquette 3 ne prend pas nécessairement appui sur les saillies 8 sur toutes sa périphérie ; elle peut le faire uniquement à ses deux extrémités dans le cas d'une plaquette étroite. La plaquette 3 laisse bien entendu le libre passage aux connecteurs de puissance 5.

La plaquette 3 est ainsi parfaitement positionnée parallèlement aux plaquettes 1.

La plaquette 3 porte par exemple divers circuits imprimés ainsi que des composants à montage en surface rapportés sur la face supérieure et éventuellement inférieure de la plaquette 3.

A titre d'exemple, les circuits bas portés par les plaquettes 1 sont recouverts d'une première résine 9, molle, telle qu'une résine siliconée, cette première couche étant surmontée d'une seconde résine 10, plus dure, telle que de la résine époxy, noyant totalement le niveau mi-hauteur du module.

Bien entendu, on peut prévoir un seul type et une seule couche de résine noyant l'ensemble des circuits.

En surface du module font saillies, d'une part, les connecteurs de puissance 5 dont les extrémités peuvent être recourbées pour former des bornes à visser 11, pour raccordement des circuits bas au circuit électronique de puissance auquel est destiné le module, et, d'autre part, les connecteurs 12, dits de petits signaux, reliés aux circuits à mi-hauteur de la plaquette 3.

Pour assurer un bon maintien en place des circuits à mi-hauteur, les saillies 8 ont avantageusement une section en queue d'aronde ou analogue sur laquelle s'accroche et se bloque la couche de résine 10. Toute autre section, y compris rectangulaire ou carrée, des saillies 8 est évidemment possible.

La fabrication de ces modules s'effectue de la manière suivante.

Après réalisation des circuits de la plaquette 3, d'une part, et des circuits des plaquettes 1 ainsi que leur fixation sur la semelle 2, d'autre part, les ressorts 4 sont soudés à leur extrémité inférieure aux plaquettes 1 à l'aide d'une plaque de guidage 13 (figure 2) percée de trous cylindriques 14 très légèrement supérieurs au diamètre des ressorts 4.

La plaque 13 est placée au-dessus de la semelle 2, parallèlement à celle-ci et de manière que lesdits trous 14 se trouvent à l'aplomb des endroits des plaquettes 1 où doivent être soudés les ressorts 4. Les ressorts 4 sont introduits dans les trous 14. L'épaisseur de la plaque 13 est suffisante pour conserver une parfaite verticalité aux ressorts.

Une fois exécutée la soudure de l'extrémité inférieure des ressorts 4 sur les circuits des plaquettes 1, la plaque 13 est retirée. Les ressorts 4, grâce justement à leur rigidité élastique, demeurent bien verticaux et reviennent d'eux mêmes en position verticale après un choc, en sorte que la phase suivante du processus, à savoir la mise en place du mur 6 et la pose de la plaquette 3 sur la banquette 8 de façon que les extrémités supérieures des ressorts 4 traversent les trous ménagés dans la plaquette 3, ne présente aucune difficulté.

Les trous de la plaquette 3 ont un diamètre légèrement supérieure à celui des ressorts 4. Une fois la plaquette 3 en place, les extrémités supérieures des ressorts font légèrement saillie à une hauteur constante au dessus de la plaquette en sorte que le soudage de ces extrémités aux circuits de la plaquette 3 ne présente aucune difficulté.

Ensuite, on moule les deux résines 9 et 10, ou la résine s'il y en a qu'une. Les liaisons élastiques 4 ainsi constituées supportent sans aucun problème les éventuelles dilatations résultant d'une élévation de température, qu'elle provienne des circuits de puissance du niveau bas ou de l'environnement du module, ainsi que les chocs.

Dans le mode de réalisation décrit et représenté, il est question d'un module à deux niveaux, mais on pourrait bien entendu prévoir un nombre de niveaux supérieur à deux, en superposant au-dessus de la semelle 2 plusieurs substrats tels que 3, à plusieurs hauteurs et reliés entre eux par des liaisons électriques à ressorts identiques aux liaisons 4 ci-dessus.

Enfin, l'invention n'est pas limitée aux modes de réalisation décrits ou évoqués ci-dessus mais en couvre au contraire toutes les variantes notamment en ce qui concerne les caractéristiques des ressorts 4 (diamètre, pas, nature du matériau constitutif, diamètre du fil utilisé) qui peuvent varier selon les applications, ainsi que les formes, agencements et dimensions des moyens d'appui et positionnement 8 de la plaquette 3 portant les circuits à mi-hauteur.

**Revendications**

1. Procédé d'assemblage de circuits de puissance et de circuits de commande sur plusieurs niveaux sur un même module, caractérisé en ce qu'il consiste :
- à regrouper sur un niveau, dit bas, les circuits de puissance, montés sur une ou plusieurs plaquettes de céramique (1) solidarisées d'une semelle (2) dissipatrice de chaleur,
- à regrouper sur au moins un niveau, dit à mi-hauteur, les circuits de commande, montés sur un substrat approprié (3),
- à constituer les liaisons électriques entre les circuits des deux niveaux susdits par des pièces en forme de ressorts hélicoïdaux (4) en matériau métallique relativement rigide et soudable, disposés verticalement,
- à souder les extrémités inférieures desdits ressorts (4) aux endroits appropriés des circuits du niveau bas (1), en maintenant les ressorts à l'aide d'une plaque de guidage (13) percée de trous (14) de passage des ressorts, ladite plaque servant également au positionnement en vue du soudage des connecteurs de puissance (5),

- à fixer le mur (6) du module sur ladite semelle (2),

- à placer à l'intérieur du mur, à l'aide de saillies de positionnement (8) conformées sur la paroi interne dudit mur, le substrat (3) portant les circuits de commande,

- à souder les extrémités supérieures desdits ressorts (4) aux endroits appropriés sur la face supérieure dudit substrat (3), muni à cet effet de trous de passage des ressorts, et, enfin,

- à remplir de résine l'intérieur du mur (6) en recouvrant le niveau bas et le niveau à mi-hauteur, les connecteurs de puissance (5) et de petits signaux (12) dépassant de la couche de résine.

2. Procédé suivant la revendication 1, caractérisé en ce qu'au cours du moulage du mur (6) on réalise également par moulage une banquette (8) courant de manière continue ou discontinue sur la face intérieure du mur au(x) niveau(x) du ou des substrat(s) (3) placés en superposition.

3. Module notamment de puissance réalisé suivant le procédé de la revendication 1 ou 2, caractérisé en ce qu'il comprend un niveau bas où sont regroupés, sur une ou plusieurs plaquettes en céramique (1), les circuits de puissance et au moins un niveau supérieur, dit à mi-hauteur, où sont regroupés les circuits dits de commande reliés aux circuits du niveau bas par des liaisons électriques constituées par des ressorts hélicoïdaux (4) disposés verticalement et soudés à leurs extrémités aux circuits correspondants des deux niveaux, l'ensemble des deux niveaux étant noyé dans une résine.

4. Module suivant la revendication 3, caractérisé en ce que le substrat (3) portant les circuits dits à mi-hauteur est supporté par une banquette (8) ou analogue conformée sur la paroi interne du mur (6) entourant les circuits du module.

5. Module suivant la revendication 4, caractérisé en ce que ladite banquette (8) a une section en queue d'aronde ou similaire.

6. Module suivant la revendication 4 ou 5, caractérisé en ce que le niveau bas est recouvert d'une masse d'une première résine (9), molle, cependant que le niveau à mi-hauteur est noyé dans la masse d'une seconde résine (10) plus dure.

FIG-1-

FIG-2-

FIG_3_

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-2 080 949 (SPERRY RAND) <br> * Page 4, lignes 1-16 * <br> --- | 1,3 | H 05 K 5/00 |
| A | US-A-3 383 565 (D.M. GRITTON) <br> * Colonne 2, lignes 32-58 * <br> --- | 1 | |
| A | US-A-4 558 510 (TANI et al.) <br> * Colonne 1, lignes 16-60 * <br> --- | 1,6 | |
| A | US-A-4 092 487 (IMAI) <br> * Colonne 2, lignes 6-24 * <br> --- | 1,4,6 | |
| A | EP-A-0 138 697 (THOMSON-CSF) <br> * Page 2, ligne 1 - page 3, ligne 20 * <br> ----- | 1 | |

**DOMAINES TECHNIQUES RECHERCHES (Int. Cl.4)**

H 05 K

Le présent rapport a été établi pour toutes les revendications

| Lieu de la recherche | Date d'achèvement de la recherche | Examinateur |
|---|---|---|
| LA HAYE | 10-08-1988 | TOUSSAINT F.M.A. |